Europäisches Patentamt

European Patent Office

Office européen des brevets

(19)

(11) Numéro de publication : **0 016 674**
**B1**

# FASCICULE DE BREVET EUROPÉEN

(12)

(45) Date de publication du fascicule du brevet :
22.06.83

(51) Int. Cl.³ : **H 03 D 9/04, H 03 L 7/04**

(21) Numéro de dépôt : **80400255.8**

(22) Date de dépôt : **22.02.80**

(54) **Dispositif discriminateur de fréquence et oscillateur hyperfréquence stabilisé par un tel dispositif.**

(43) Date de publication de la demande :
01.10.80 Bulletin 80/20

(45) Mention de la délivrance du brevet :
22.06.83 Bulletin 83/25

(84) Etats contractants désignés :
**DE GB IT NL**

(56) Documents cités :
**DE A 2 720 240**
**FR A 1 539 536**
**FR A 2 003 057**
**US A 4 048 580**

(73) Titulaire : **THOMSON-CSF**
**173, Boulevard Haussmann**
**F-75379 Paris Cedex 08 (FR)**

(72) Inventeur : **Pierrot, Robert**
**"THOMSON-CSF" - SCPI 173, bld Haussmann**
**F-75360 Paris Cedex 08 (FR)**

(74) Mandataire : **Eisenbeth, Jacques Pierre et al**
**THOMSON-CSF SCPI 173, Bld Haussmann**
**F-75379 Paris Cedex 08 (FR)**

**EP 0 016 674 B1**

Jouve, 18, rue St-Denis, 75001 Paris, France

Dispositif discriminateur de fréquence et oscillateur hyperfréquence stabilisé par un tel dispositif

La présente invention concerne un dispositif discriminateur de fréquence, pour stabiliser un oscillateur hyperfréquence et un oscillateur hyperfréquence stabilisé par un tel dispositif.

Les oscillateurs de faible puissance utilisés dans le domaine des hyperfréquences et nécessitant une bonne stabilité en fréquence sont souvent du type à quartz. Ils comportent alors au moins un étage délivrant un signal à une fréquence correspondant au quartz choisi suivi d'un multiplicateur de fréquence permettant d'obtenir des fréquences de l'ordre de 10 GHz. La sortie de ce multiplicateur de fréquence est souvent reliée à un amplificateur permettant d'obtenir la puissance désirée. Toutefois ces oscillateurs présentent deux inconvénients qui peuvent s'avérer gênants dans certains équipements ; d'une part la fréquence est fixe et d'autre part le bruit de phase propre à l'oscillateur à quartz de base remonte proportionnellement au rang de la multiplication de fréquence, ce qui est gênant pour des fréquences très élevées.

On peut utiliser également des oscillateurs à circuit résonnant comparables à ceux utilisés dans les équipements radioélectriques fonctionnant en moyenne et haute fréquence. Dans le domaine des hyperfréquences, ils peuvent être réalisés par exemple à l'aide de cavités ou de résonateurs à lignes sur substrat, en technique « micro-strip » ou « triplaque » et d'éléments actifs comme les diodes de type « gunn » ou « avalanche ». Les oscillateurs ne présentent cependant pas une stabilité en fréquence et phase suffisante pour les équipements modernes.

Suivant l'art antérieur on réalise cette stabilité en fréquence de ces oscillateurs à lignes et éléments actifs du type, par exemple, des diodes « gunn » ou « avalanche », par une boucle de verrouillage de fréquence utilisant une ligne à retard acoustique. On obtient alors des oscillateurs appelés oscillateurs à compression de bruit.

Ces lignes acoustiques sont de coût élevé et limitées actuellement aux fréquences de la bande X, gamme dans laquelle les oscillateurs à quartz ont de meilleures performances de bruit de fréquence et de phase. De plus elles sont limitées fortement en puissance, et présentent des pertes pouvant aller jusqu'à 30 ou 40 dB, et introduisent un retard $\tau$ important créant des ambiguïtés sur la fréquence de référence égales à $1/\tau$. Cette ambiguïté peut être alors tous les 2 MHz si $\tau$ = 0,5 $\mu$ sec.

Le dispositif selon l'invention a pour objet un discriminateur de fréquence permettant le verrouillage en phase de l'oscillateur, auquel il est associé. L'un des avantages d'un tel discriminateur est de supprimer l'utilisation des lignes acoustiques limitant les oscillateurs à des fréquences de 10 GHz.

Selon l'invention le dispositif discriminateur de fréquence pour stabiliser un oscillateur hyperfréquence équipé d'une entrée de commande en fréquence, comprenant :

— un premier moyen de couplage dont l'entrée reçoit le signal généré par l'oscillateur hyperfréquence et qui délivre un signal correspondant à la moitié de la puissance de sortie de l'oscillateur hyperfréquence à l'entrée d'une première et d'une deuxième ligne de transmission électromagnétique respectivement, la deuxième ligne de transmission électromagnétique introduisant par rapport à la première ligne un retard $\tau$ déterminant la fréquence d'accord dudit discriminateur de fréquence ;

— un deuxième moyen de couplage recevant le signal de sortie des première et deuxième lignes de transmission électromagnétiques et délivrant sur une première sortie un signal qui représente la somme vectorielle des deux signaux d'entrée et correspond au signal de sortie stabilisé en fréquence de l'oscillateur hyperfréquence et sur une deuxième sortie un signal représentant la différence vectorielle desdits signaux d'entrée ;

— un troisième moyen de couplage recevant sur une première entrée le signal délivré par la deuxième sortie du deuxième moyen de couplage ;

— un quatrième moyen de couplage prélevant une partie du signal hyperfréquence de l'oscillateur et appliquant le signal prélevé sur la deuxième entrée du troisième moyen de couplage ; et

— un détecteur alimenté par le signal de sortie du troisième moyen de couplage et délivrant à l'entrée de commande en fréquence de l'oscillateur un signal de commande en fréquence dont l'amplitude dépend de l'écart de fréquence par rapport à la fréquence d'accord dudit discriminateur est caractérisé en ce que le quatrième moyen de couplage prélève une partie du signal transmis par la deuxième ligne électromagnétique entre les premiers et deuxième moyens de couplage.

D'autres avantages et caractéristiques de la présente invention apparaîtront dans la description qui suit, donnée à l'aide des figures qui représentent :

la figure 1, le bloc diagramme général d'un oscillateur stabilisé par un discriminateur de fréquence ;

la figure 2, un schéma d'un discriminateur de fréquence selon l'Art Antérieur, utilisant une ligne acoustique, utilisé avec l'oscillateur de la figure 1 ;

la figure 3, un schéma vectoriel illustrant les opérations faites par le dispositif selon l'invention ;

la figure 4, un schéma détaillé d'un dispositif discriminateur proche de celui de l'invention ;

la figure 5, un exemple non limitatif de réalisation d'un dispositif discriminateur proche de celui de l'invention.

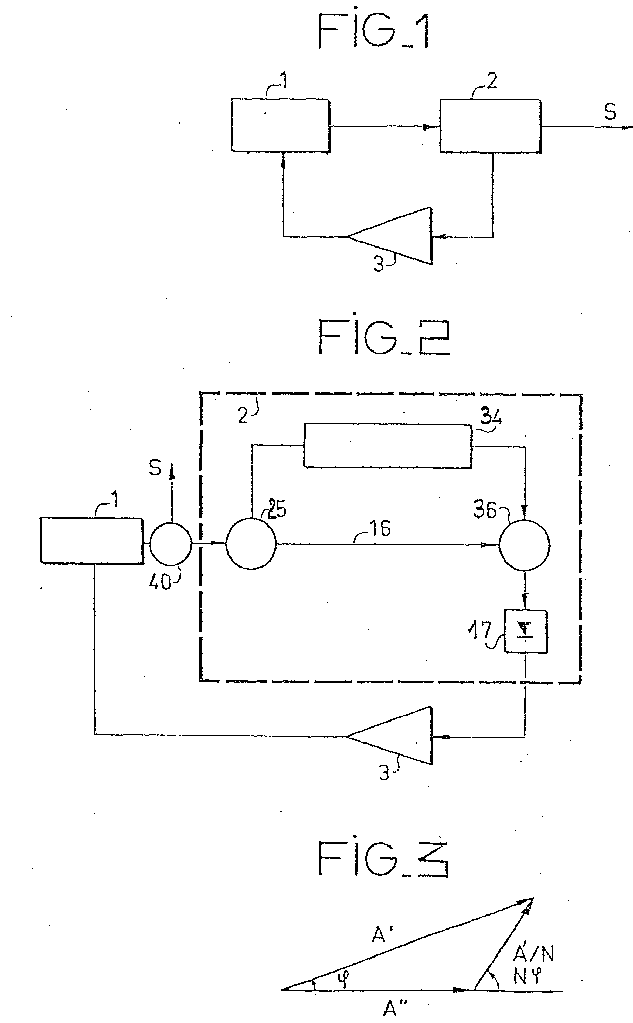

Un oscillateur à boucle de verrouillage en fréquence commandée par un circuit discriminateur de fréquence est représenté par le bloc diagramme de la figure 1.

Il comporte un circuit oscillateur proprement dit 1, dont la sortie est connectée à l'entrée d'un discriminateur de fréquence 2. Celui-ci délivre sur une sortie S l'onde stabilisée en fréquence et sur la seconde un signal, dont l'amplitude varie avec l'écart par rapport à la fréquence d'accord, appliqué à l'entrée d'un amplificateur 3 ; la sortie de celui-ci est connectée à la commande en fréquence du circuit oscillateur 1.

Le fonctionnement d'un tel oscillateur à boucle de verrouillage est le suivant, donné à l'aide de la figure 2 représentant un discriminateur de fréquence selon l'art antérieur. Le discriminateur 2 reçoit le signal de sortie de l'oscillateur 1. Il compare la fréquence f de celui-ci avec une fréquence de référence $f_o$ déterminée par une ligne à retard 4 présentant un retard $\tau$. Un signal dont l'amplitude est fonction de l'écart de fréquence $f - f_o$ permet de faire varier la fréquence f de l'oscillateur 1, en agissant par exemple sur la tension d'une diode varactor.

La figure 2 montre un schéma d'un discriminateur de fréquence de l'art antérieur utilisé avec le type d'oscillateur de la figure 1. Il comporte un coupleur 40 délivrant le signal utile de sortie à une borne S, un coupleur 25 permettant de diviser l'onde incidente en deux ondes d'inégale puissance et donc d'amplitude différente. Ce coupleur 25 est connecté à deux lignes de transmission 34 et 16. La ligne la plus courte 16, est une ligne transmettant directement l'onde électromagnétique issue du coupleur 25 à la première entrée d'un second coupleur 36. La seconde ligne 34, est une ligne acoustique comprenant à son entrée un transducteur émetteur, transformant l'onde électromagnétique en onde ultrasonore, et à sa sortie un transducteur récepteur retransformant l'onde ultrasonore en onde électromagnétique qui est appliquée à la seconde entrée du coupleur 36. La vitesse des ondes sonores dans un milieu quelconque, étant beaucoup plus faible que la vitesse des ondes électromagnétiques dans une ligne de transmission, les ondes issues de la ligne de transmission 34 sont en retard d'un temps $\tau$ de valeur importante par rapport à celles issues de la ligne de transmission 16. Le signal issu du coupleur 36 est transformé en un signal dont l'amplitude croît avec l'écart de fréquence $f - f_o$ par un circuit détecteur 17. Dans cet exemple $f_o$ est déterminé par une coïncidence de phase des deux ondes aux entrées du coupleur 36, donc par la relation $f_o = k1/\tau$ où k est un nombre entier positif.

Les lignes acoustiques introduisent un retard important du fait de la grande différence de vitesse, celui-ci atteint couramment des valeurs de l'ordre de 0,5 µ sec. Cette grande valeur de $\tau$ provoque donc une ambiguïté sur la fréquence $f_o$ qui dans l'exemple précédent se répète tous les 2 MHz. Le signal sortant du détecteur 17, a pour amplitude A sin $\varphi$ où $\varphi = 2 \pi (f - f_o) \tau$ ; cette expression en général peut s'écrire A $\varphi$ car l'angle reste suffisamment petit du fait de la valeur du produit $\tau (f - f_o)$. Si le retard $\tau$ est diminué, de

façon à ce que les fréquences ambiguës soient plus espacées, le produit A$\varphi$ diminue, ce qui entraîne une diminution du gain de boucle. De plus le détecteur, par exemple constitué de diodes « Schottky », est toujours limité en puissance ce qui entraîne par conséquent une limitation sur A également, accentuant le manque de sensibilité de la boucle, fonction de l'amplitude du signal à l'entrée de l'amplificateur 3.

Les inconvénients des dispositifs suivant l'art antérieur dépendent donc fortement de l'utilisation d'une ligne acoustique et de la puissance limitée que l'on peut appliquer à l'entrée du détecteur 7.

Le dispositif selon l'invention tend à supprimer ces inconvénients. La ligne acoustique de retard 34 est remplacée par une ligne de transmission électromagnétique 4 qui introduit toutefois un retard $\tau$ petit, pouvant être par exemple de 5 n sec, beaucoup plus petit que celui introduit par la ligne acoustique. L'avantage cependant de la ligne électromagnétique est d'éviter les pertes et les limitations en puissance inhérentes aux lignes acoustiques. L'introduction de cette ligne électromagnétique entraîne également un élargissement de l'espacement entre les fréquences ambiguës mais une diminution du déphasage $\varphi$ entre les lignes 4 et 16 et donc du signal A $\varphi$ à la sortie du coupleur 6. Cette modification semblerait ne présenter aucun intérêt car elle tend à faire diminuer encore plus la sensibilité au niveau du détecteur 7. Suivant l'invention on pallie cet inconvénient et la figure 3 montre le procédé utilisé pour ce faire. Si l'on appelle A' et A'' les amplitudes, a priori légèrement différentes, des signaux apparaissant sur les lignes 4 et 16, l'amplitude du signal à la sortie du détecteur 7 est donnée par :

$$\|\Delta\| = A' \sin \varphi \# A' \varphi$$

si $\varphi$ le déphasage introduit par les lignes 4 et 16 est petit, ce qui a été énoncé précédemment. Cette expression peut s'écrire en introduisant un nombre N positif quelconque :

$$\|\Delta\| \# (A'/N) \cdot (N \varphi)$$

elle signifie qu'augmenter l'amplitude des signaux issus de l'oscillateur 1 est équivalent à augmenter la phase $\varphi$. Ainsi le remplacement de la ligne acoustique par une ligne électromagnétique permet cette forte augmentation de la puissance au niveau du coupleur 6 et donc de l'amplitude A' par un facteur N' mais ceci pourrait entraîner la destruction du détecteur 7. On est conduit à introduire un autre coupleur 12 qui élabore le signal $\Delta$ d'amplitude moyenne égale à :

$$\|\Delta\| = (A' N'/N) \cdot (N \varphi)$$

cette sortie du coupleur 12 est appliquée sur le coupleur 6 ainsi qu'une partie du signal délivré par l'oscillateur avant ou après qu'il soit stabilisé.

C'est à la sortie de ce coupleur 6 qu'est connecté le détecteur 7.

Dans ce nouveau montage on réalise ainsi une série d'opérations équivalentes à une multiplication de phase, ce qui bien sûr augmente la sensibilité du discriminateur. Ces opérations ne sont pas dangereuses pour le détecteur 7 car à l'entrée du coupleur 6 la puissance est beaucoup moins forte qu'à l'entrée du coupleur 36 (Fig. 2) selon l'art antérieur et donc a fortiori la puissance à sa sortie est suffisamment faible pour éviter la destruction du détecteur 7.

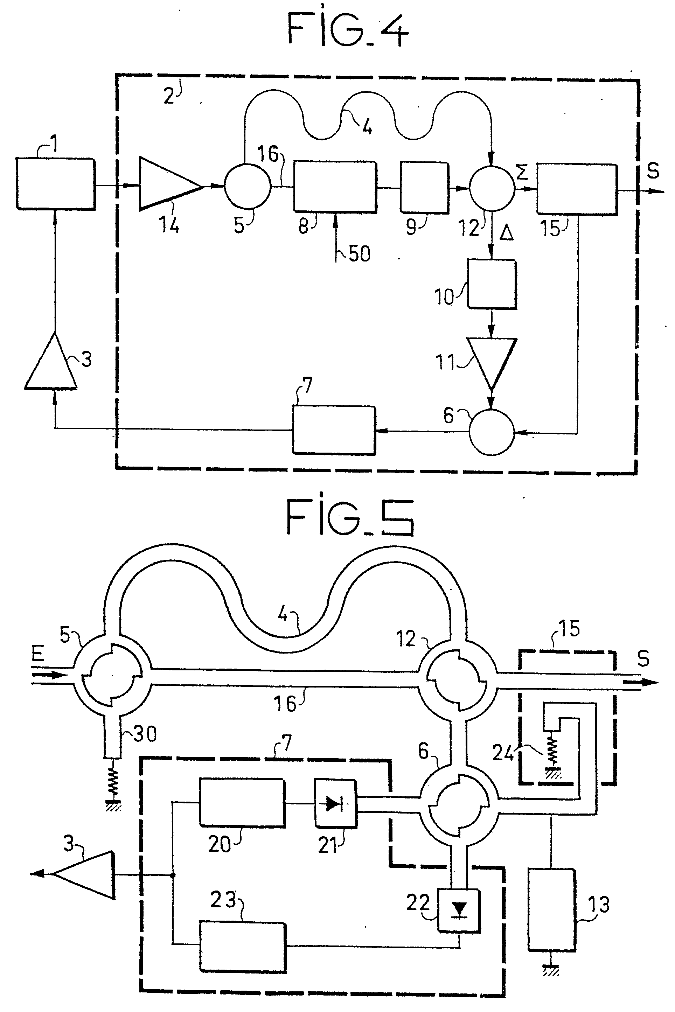

La figure 4 donne un schéma détaillé d'un dispositif proche du discriminateur selon l'invention réalisant ces opérations. Le discriminateur, représenté par la figure 4 à titre d'information, est un dispositif intermédiaire entre le discriminateur selon l'invention et le système de verrouillage en phase d'un oscillateur tel que décrit par le brevet français FR-1 539 536 de Western Electric Company Inc., dont il reprend certaines caractéristiques.

Comme dans le brevet français mentionné ci-dessus, le discriminateur de la figure 4 comprend quatre moyens de couplage 5, 12, 6, 15 et deux lignes de transmission 16, 4 dont la première 16 est directe et la seconde 4 introduit un retard $\tau$ par rapport à la première. Ces deux lignes sont placées en parallèle entre les deux premiers moyens de couplage 5, 12. Le troisième moyen de couplage 6 reçoit d'une part un signal $\Delta$ délivré par le deuxième moyen de couplage 12 sur une sortie et correspondant à la différence vectorielle de ses deux signaux d'entrée transmis par les lignes de transmission parallèles 16, 4. Il reçoit d'autre part un autre signal prélevé par le quatrième coupleur 15 en un point du discriminateur 2 et correspondant à une partie du signal hyperfréquence stabilisé ou non. Un détecteur 7 connecté en sortie du troisième moyen de couplage 6 délivre, à l'entrée de commande de l'oscillateur 1 à stabiliser, un signal dont l'amplitude dépend de l'écart de fréquence par rapport à la fréquence d'accord du discriminateur déterminée par le retard $\tau$.

Le quatrième coupleur 15 peut prélever en différents points du discriminateur le signal à appliquer sur la deuxième entrée du troisième coupleur 6 et ceci avec des performances variables :

— premier cas : A l'image du brevet français FR-1 539 536, il peut être placé, comme illustré par la figure 4 dont le détail est donné par la figure 5, en aval du deuxième coupleur 12 et prélever sur son autre sortie $\Sigma$ une partie du signal qui, formé par la somme vectorielle des deux signaux d'entrée transmis par les deux lignes de transmission parallèles 16, 4, correspond au signal hyperfréquence stabilisé de l'oscillateur 1 ;

— deuxième cas : A l'image du brevet allemand DE-OS-2 720 240, le point de prélèvement peut être situé entre le premier coupleur 5 et la sortie de l'oscillateur hyperfréquence 1. Ce mode de réalisation n'a pas été représenté. Ses performances sont identiques à celles du premier cas ;

— troisième cas : le point de prélèvement est placé sur une ligne de transmission. Sur la première ligne de transmission directe 16, le cas est analogue au deuxième cas ci-dessus. Le mode de réalisation non représenté où le signal est prélevé sur la deuxième ligne de transmission à retard 4 fait l'objet de l'invention.

Selon un mode de réalisation préférentiel, non représenté, le point de prélèvement est le point milieu de la ligne 4.

Le dispositif discriminateur de fréquence de la figure 4 comporte de plus, un amplificateur 14 recevant la sortie de l'oscillateur 1, et dont la sortie est connectée au premier coupleur 5.

Dans la première ligne de transmission 16, de même type que la ligne 4 mais plus courte, sont insérés en série un circuit de déphasage 8 à commande extérieure 50 et un atténuateur 9.

La sortie $\Delta$ du deuxième coupleur 12 est de façon préférentielle connectée au troisième coupleur 6 par l'intermédiaire d'un circuit limiteur 10 monté en série avec un amplificateur 11 à faible bruit. Le coupleur 6 reçoit sur sa seconde entrée le signal prélevé par le quatrième coupleur 15. La ou les sorties de ce coupleur 6 sont connectées au circuit détecteur 7.

Le fonctionnement d'un tel dispositif (figure 4) est le suivant : le signal à la fréquence $f$ issue de l'oscillateur 1 est amplifié par l'amplificateur 14. Le coupleur 5 répartit la puissance de façon égale entre les deux lignes 4 et 16. La ligne 4, plus longue que la ligne 16, introduit un retard $\tau$ par rapport à la ligne 16 ; ce retard peut être réglé en utilisant le circuit 8 de déphasage qui modifie la fréquence d'accord de l'oscillateur 1. L'atténuateur 9 permet de ramener à une même amplitude les deux signaux délivrés par les lignes 4 et 16, au coupleur 12. La voie $\Sigma$ de ce coupleur 12 délivre alors une onde dont l'amplitude ne dépend, aux pertes des lignes 4 et 16 près, que de l'oscillateur 1 et de l'amplificateur 14. La voie $\Delta$ délivre un signal dont l'amplitude est faible quand la boucle est accrochée du fait de la différence vectorielle des deux ondes. Le circuit limiteur 10 limite la transmission d'énergie dans la voie $\Delta$ afin que les circuits situés en aval, comme le circuit détecteur 7, ne soient pas détruits ; une puissance importante peut en effet éventuellement se trouver sur $\Delta$ durant la phase d'accrochage de la boucle en fréquence car alors le signal $\Delta$ peut être très important du fait de l'écart à l'instant de démarrage.

L'amplificateur 11 à faible bruit permet d'obtenir un signal plus important rendant négligeable les bruits propres du détecteur 7 et de l'amplificateur 3. On obtient donc sur les entrées du coupleur 6 des signaux d'amplitude comparable à ceux que l'on avait sur le coupleur 36 dans les réalisations de l'art antérieur comme celle montrée sur la figure 2.

Un tel dispositif permet donc de disposer d'une puissance importante à la sortie du coupleur 15 et de n'en utiliser qu'une petite partie pour effectuer la détection et ainsi d'éviter la destruction des circuits 7 de détection. De plus si A' est l'amplitude des signaux issus des lignes 4 et 16 (A' étant peu différent de A") et φ leur différence de phase, on obtient à l'entrée du coupleur 6, un signal d'amplitude G'A'φ où G' est le gain de l'amplificateur 11. L'amplitude du signal prélevé par le coupleur 15 et appliqué à l'entrée du coupleur 6 doit être notablement supérieur à G'A' φ par exemple à 10 dB au-dessus. G'A' φ est calculé de façon à être le plus grand possible dans la limite acceptable par le détecteur 7.

La sortie du coupleur 6 délivre ainsi un signal fonction de φ d'amplitude assez importante tout en restant compatible avec l'admissibilité du détecteur 7. L'amplificateur 11 situé dans la ligne issue de la voie de sortie Δ du coupleur 12 a pour effet de réduire le bruit de la boucle de verrouillage en fréquence.

En effet le bruit a essentiellement pour origine l'ensemble détecteur 7, amplificateur 3, donc si une partie du gain de l'amplificateur 3 est faite par l'amplificateur 11, conçu pour être à plus faible bruit que l'amplificateur 3, le bruit total de la boucle diminue car il est bien connu que le bruit ne dépend dans une chaîne d'amplification, que du premier étage dans la mesure où le gain du premier étage est suffisant.

Un exemple détaillé de réalisation non limitatif du dispositif de la figure 4, très proche de celui selon l'invention est montré sur la figure 5 qui ne comprend que les éléments strictement nécessaires au dispositif réalisé sur substrat en technique « micro-strip » ou « triplaque ». Il reprend les éléments de la figure 4, excepté les amplificateurs 11 et 14, le limiteur 10, le circuit de déphasage 8 et l'atténuateur 9. Le détecteur 7 comporte deux diodes 21 et 22 par exemple du type « Schottky » connectées avec des polarités inverses entre chaque sortie du coupleur 6 et un filtre passe-bas 20 et 23 respectivement permettant un lissage du signal détecté. Les sorties des filtres 20 et 23 sont interconnectées et appliquées à l'entrée de commande en fréquence de l'oscillateur 1 via l'amplificateur 3. Un filtre passe-bas 13 assure le retour de masse du détecteur 7. Le coupleur 15 connecté ici en aval du deuxième coupleur mais qui dans le dispositif selon l'invention est disposé sur la deuxième ligne de transmission 4, comporte deux tronçons de ligne suffisamment proche pour établir un couplage faible et l'un de ces tronçons, celui qui est relié au coupleur 6, à sa seconde extrémité terminée par une résistance 24 évitant des réflexions d'ondes. De même le coupleur 5 est choisi à quatre entrées, dont une sur charge adaptée, de façon à éviter les réflexions d'ondes dans les lignes 4 et 16. Les coupleurs 5, 6 et 12 sont des coupleurs hybrides à 4 entrées ou sorties dont la forme, caractéristique de la réalisation sur substrat en « micro-strip » ou « triplaque » est bien connue.

Le temps τ de retard entre les lignes 4 et 16 est donc selon l'invention très court de l'ordre par exemple de 5 ns. Ceci correspond à une fréquence des ambiguïtés de fréquence de 200 MHz. Cet intervalle beaucoup plus large que dans l'art antérieur, permettant en outre un balayage à large bande en fréquence de l'oscillateur par variation de la fréquence d'accord du discriminateur par exemple à l'aide d'un déphaseur, est également un avantage d'un tel mode de réalisation.

De plus, le coût total de réalisation baisse considérablement du fait de la non-utilisation de ligne acoustique.

Le dispositif selon l'invention peut également utiliser des guides d'onde. La puissance peut alors être plus élevée et les capteurs 5, 6 et 12 sont par exemple des « Tés magiques ».

Dans le mode de réalisation selon l'invention, non représenté sur les figures, le capteur 15 est intercalé entre les deux coupleurs 5 et 12 sur la ligne de transmission à retard 4 et selon un mode préférentiel mais non limitatif, au point milieu de cette ligne. En fait, il est possible de placer ce coupleur 15 à un endroit quelconque de la ligne à retard 4.

La bande de fréquence du discriminateur selon l'invention, c'est-à-dire la bande de fréquence sans ambiguïté, est considérablement augmentée par rapport à celle d'un discriminateur tel que représenté par la figure 4.

Dans le mode de réalisation particulier où le point de prélèvement du signal par le quatrième coupleur 15 est le point milieu de la ligne à retard 4 (où le signal transmis par la deuxième ligne 4 est retardé de τ/2 par rapport à celui transmis par la ligne directe 16) la bande de fréquence sans ambiguïté, donc correspondant à un fonctionnement satisfaisant du discriminateur, est doublée par rapport à la bande de fréquence du dispositif dans lequel le prélèvement se fait en dehors de la ligne à retard 4.

On a ainsi décrit un discriminateur de fréquence dont la limite en fréquence et en puissance d'entrée est beaucoup plus élevée et permettant du fait de l'augmentation de cette puissance une meilleure précision sur les écarts de phase et donc de fréquence par rapport à la fréquence de référence déterminée par le retard τ existant entre les lignes de transmission 4 et 16.

**Revendications**

1. Dispositif discriminateur de fréquence pour stabiliser un oscillateur hyperfréquence équipé d'une entrée de commande en fréquence, comprenant :

— un premier moyen de couplage (5) dont l'entrée reçoit le signal généré par l'oscillateur hyperfréquence (1) et qui délivre un signal correspondant à la moitié de la puissance de sortie de l'oscillateur hyperfréquence (1) à l'entrée d'une première et d'une deuxième ligne de transmission électromagnétique (16 et 4) respectivement, la deuxième ligne de transmission électromagnétique (4) introduisant par rapport à la première ligne (16) un retard τ déterminant la fréquence d'accord dudit discriminateur de fréquence ;

— un deuxième moyen de couplage (12) rece-

vant le signal de sortie des première et deuxième lignes de transmission électromagnétiques (16 et 4) et délivrant sur une première sortie Σ un signal qui représente la somme vectorielle des deux signaux d'entrée et correspond au signal de sortie stabilisé en fréquence (S) de l'oscillateur hyperfréquence (1) et sur une deuxième sortie Δ un signal représentant la différence vectorielle desdits signaux d'entrée ;

— un troisième moyen de couplage (6) recevant sur une première entrée le signal délivré par la deuxième sortie Δ du deuxième moyen de couplage (12) ;

— un quatrième moyen de couplage (15) prélevant une partie du signal hyperfréquence de l'oscillateur (1), et appliquant le signal prélevé sur la deuxième entrée du troisième moyen de couplage (6) ; et

— un détecteur (7) alimenté par le signal de sortie du troisième moyen de couplage (6) et délivrant à l'entrée de commande en fréquence dont l'oscillateur (1) un signal de commande en fréquence dont l'amplitude dépend de l'écart de fréquence par rapport à la fréquence d'accord dudit discriminateur, caractérisé en ce que le quatrième moyen de couplage (15) prélève une partie du signal transmis par la deuxième ligne électromagnétique (4) entre les premier et deuxième moyens de couplage (5 et 12).

2. Dispositif discriminateur selon la revendication 1, caractérisé en ce que le signal appliqué sur la deuxième entrée du troisième moyen de couplage (6) est prélevé par le quatrième moyen de couplage (15) au point milieu de la deuxième ligne électromagnétique (4) retardée.

3. Dispositif discriminateur de fréquence selon l'une quelconque des revendications 1 et 2, caractérisé en ce que le retard τ de la seconde ligne de transmission (4) par rapport à la première (16) est ajusté par un circuit déphaseur (8) comportant une entrée de commande extérieure et disposé sur la première ligne de transmission (16).

4. Dispositif discriminateur de fréquence selon l'une quelconque des revendications 1 et 2, caractérisé en ce qu'il comporte un amplificateur (14) entre la sortie de l'oscillateur (1) et l'entrée du premier moyen de couplage (5).

5. Dispositif discriminateur de fréquence selon l'une quelconque des revendications 1 et 2, caractérisé en ce que la première ligne de transmission électromagnétique (16) comprend un atténuateur (9).

6. Dispositif discriminateur de fréquence selon l'une quelconque des revendications 1 et 2, caractérisé en ce qu'il comprend un circuit limiteur de puissance (10) entre la deuxième sortie du deuxième moyen de couplage (12) et la première entrée du troisième moyen de couplage (6).

7. Dispositif discriminateur de fréquence selon l'une quelconque des revendications 1 et 2, caractérisé en ce qu'il comprend un amplificateur faible bruit (11) entre la deuxième sortie du second moyen de couplage (12) et la première entrée du troisième moyen de couplage (6).

8. Dispositif discriminateur de fréquence selon l'une quelconque des revendications 1 à 7, caractérisé en ce que les premier, deuxième, troisième moyens de couplage (5, 12, 6) sont des coupleurs hybrides.

9. Oscillateur hyperfréquence stabilisé en fréquence par un dispositif discriminateur (2) selon l'une quelconque des revendications 1 à 8, caractérisé en qu'il comporte une sortie délivrant un signal hyperfréquence appliqué à l'entrée du premier moyen de couplage (5) du dispositif discriminateur de fréquence (2) et une entrée de commande en fréquence recevant le signal de sortie du détecteur (7) du dispositif discriminateur de fréquence (2) via un amplificateur (3), la fréquence de l'oscillateur étant accordée sur la fréquence d'accord dudit discriminateur elle-même ajustée en faisant varier le retard de la transmission du signal hyperfréquence par la deuxième ligne électromagnétique (4) par rapport à la transmission du signal par la première ligne électromagnétique (16).

**Claims**

1. A frequency discriminator device used to stabilize an UHF oscillator which is equipped with a frequency control input comprising

— a first coupling means (5) receiving at its input the signal generated by the UHF-oscillator (1), and delivering a signal corresponding to half of the output power of the UHF oscillator (1) to the input of a first and a second electromagnetic transmission line (16 and 4) respectively, the second electromagnetic transmission line (4) introducing with respect to the first line (16) a delay τ which determines the tuning frequency of said frequency discriminator,

— a second coupling means (12) receiving the output signal of the first and second electromagnetic transmission lines (16 and 4) and delivering on a first output Σ a signal which represents the vectorial sum of these two input signals and which corresponds to the output signal (S), stabilized in frequency, of the UHF oscillator (1), and delivering on a second output Δ a signal which represents the vectorial difference of these input signals,

— a third coupling means (6) which receives via a first input the signal delivered by the second output Δ of the second coupling means (12),

— a fourth coupling means (15) which samples a fraction of the UHF signal of the oscillator (1) and which applies the sampled signal to the second input of the third coupling means (6), and

— a detector (7), which is fed by the output signal of the third coupling means (6) and which delivers to the frequency control input of the oscillator (1) a frequency control signal, the amplitude of which depends on the frequency shift with respect to the tuning frequency of said discriminator, characterized in that the fourth coupling means (15) samples a portion of the signal which is transmitted by the second elec-

tromagnetic line (4) between the first and second coupling means (5 and 12).

2. A discriminator device according to claim 1, characterized in that the signal applied to the second input of the third coupling means (6) is sampled from the fourth coupling means (15) at the central point of the second, delayed, electromagnetic line (4).

3. A frequency discriminator device according to any one of the claims 1 and 2, characterized in that the delay $\tau$ of the second transmission line (4) with respect to the first one (16) is adjusted by a phase shifting circuit (8) which comprises an exterior control input and which is disposed on the first transmission line (16).

4. A frequency discriminator device according to any one of the claims 1 and 2, characterized in that it comprises an amplifier (14) between the oscillator (1) output and the input of the first coupling means (5).

5. A frequency discriminator device according to any one of the claims 1 and 2, characterized in that the first electromagnetic transmission line (16) comprises an attenuator (9).

6. A frequency discriminator device according to any one of the claims 1 and 2, characterized in that it comprises a power limiting circuit (10) between the second output of the second coupling means (12) and the first input of the third coupling means (6).

7. A frequency discriminator device according to any one of the claims 1 and 2, characterized in that it comprises a low noise amplifier (11) between the second output of the second coupling means (12) and the first input of the third coupling means (6).

8. A frequency discriminator device according to any one of the claims 1 to 7, characterized in that the first, second, third coupling means (5, 12, 6) are hybrid couplers.

9. UHF oscillator which is frequency stabilized by a discriminator device (2) according to any one of claims 1 to 8, characterized in that it comprises an output which delivers an UHF signal which is applied to the input of the first coupling means (5) of the frequency discriminator device (2), and a frequency control input which receives via an amplifier (3) the output signal of the detector (7) belonging to the frequency discriminator device (2), the frequency of the oscillator being matched to the tuning frequency of said discriminator which latter frequency is adjusted by varying the delay of transmission of the UHF signal due to the second electromagnetic line (4) with respect to the transmission of the signal through the first electromagnetic line (16).


**Ansprüche**


1. Frequenzdiskriminationsvorrichtung zur Stabilisierung eines UHF-Oszillators, der mit einem Frequenzsteuereingang ausgerüstet ist, mit
— einem ersten Koppelmittel (5), dessen Eingang das vom UHF-Oszillator (1) erzeugte Signal empfängt und ein Signal, das der Hälfte der Ausgangsleistung des UHF-Oszillators (1) entspricht, an den Eingang einer ersten bzw. einer zweiten elektromagnetischen Übertragungsleitung (16 und 4) liefert, wobei die zweite elektromagnetische Übertragungsleitung (4) in Bezug auf die erste Leitung (16) eine Verzögerung $\tau$ einführt, die die Abstimmungsfrequenz des Frequenzdiskriminators bestimmt,

— einem zweiten Koppelmittel (12), das das Ausgangssignal der ersten und der zweiten elektromagnetischen Übertragungsleitung (16 und 4) empfängt und an einen ersten Ausgang $\Sigma$ ein Signal liefert, das die Vektorsumme der beiden Eigangssignale darstellt und dem frequenzstabilisierten Ausgangssignal (S) des UHF-Oszillators (1) entspricht, sowie an einem zweiten Ausgang $\Delta$ ein Signal liefert, das die Vektordifferenz dieser Eingangssignale darstellt,

— einem dritten Koppelmittel (6), das an einem ersten Eingang das vom zweiten Ausgang $\Delta$ des zweiten Koppelmittels (12) gelieferte Signal empfängt,

— einem vierten Koppelmittel (15), das einen Teil des UHF-Signals des Oszillators (1) entnimmt und das entnommene Signal an den zweiten Eingang des dritten Koppelmittels (6) anlegt, und mit

— einem Detektor (7), der das Ausgangssignal des dritten Koppelmittels (6) zugeführt erhält und am Frequenzsteuereingang des Oszillators (1) ein Frequenzsteuersignal liefert, dessen Amplitude vom Frequenzabstand in Bezug auf die Abstimmungsfrequenz des Diskriminators abhängt, dadurch gekennzeichnet, daß das vierte Koppelmittel (15) einen Teil des von der zweiten elektromagnetischen Leitung (4) zwischen dem ersten und dem zweiten Koppelmittel (5 und 12) übertragenen Signals entnimmt.

2. Diskriminationsvorrichtung nach Anspruch 1, dadurch gekennzeichnet, daß das an den zweiten Eingang des dritten Koppelmittels (6) angelegte Signal vom vierten Koppelmittel (15) am Mittelpunkt der zweiten, verzögerten, elektromagnetischen Leitung (4) entnommen wird.

3. Frequenzdiskriminationsvorrichtung nach einem beliebigen der Ansprüche 1 und 2, dadurch gekennzeichnet, daß die Verzögerung $\tau$ der zweiten Übertragungsleitung (4) in Bezug auf die erste (16) von einem Phasenverschiebungsschaltkreis (8) eingestellt wird, der einen äußeren Steuereingang aufweist und auf der ersten Übertragungsleitung (16) angeordnet ist.

4. Frequenzdiskriminationsvorrichtung nach einem beliebigen der Ansprüche 1 und 2, dadurch gekennzeichnet, daß sie einen Verstärker (14) zwischen dem Ausgang des Oszillators (1) und dem Eingang des ersten Koppelmittels (5) aufweist.

5. Frequenzdiskriminationsvorrichtung nach einem beliebigen der Ansprüche 1 und 2, dadurch gekennzeichnet, daß die erste elektromagnetische Übertragungsleitung (16) ein Dämpfungsglied (9) aufweist.

6. Frequenzdiskriminationsvorrichtung nach einem beliebigen der Ansprüche 1 und 2, dadurch gekennzeichnet, daß sie einen Leistungsbegrenzerschaltkreis (10) zwischen dem zweiten Ausgang des zweiten Koppelmittels (12) und dem ersten Eingang des dritten Koppelmittels (6) aufweist.

7. Frequenzdiskriminationsvorrichtung nach einem beliebigen der Ansprüche 1 und 2, dadurch gekennzeichnet, daß sie einen rauscharmen Verstärker (11) zwischen dem zweiten Ausgang des zweiten Koppelmittels (12) und dem ersten Eingang des dritten Koppelmittels (6) aufweist.

8. Frequenzdiskriminationsvorrichtung nach einem beliebigen der Ansprüche 1 bis 7, dadurch gekennzeichnet, daß die ersten, zweiten, dritten Koppelmittel (5, 12, 6) Hybridkoppler sind.

9. Von einer Diskriminationsvorrichtung (2) nach einem beliebigen der Ansprüche 1 bis 8 frequenzstabilisierter UHF-Oszillator, dadurch gekennzeichnet, daß er einen Ausgang aufweist, der ein UHF-Signal liefert, das an den Eingang des ersten Koppelmittels (5) der Frequenzdiskriminationsvorrichtung (2) angelegt ist, und einen Frequenzsteuereingang, der das Ausgangssignal des Detektors (7) der Frequenzdiskriminationsvorrichtung (2) über einen Verstärker (3) zugeführt erhält, wobei die Frequenz des Oszillators auf die Abstimmungsfrequenz des Diskriminators abgestimmt ist, die selbst justiert wird, indem man die durch die zweite elektromagnetische Leitung (4) bewirkte Verzögerung der Übertragung des UHF-Signals in Bezug auf die Übertragung des Signals durch die erste elektromagnetische Leitung (16) variieren läßt.

**0 016 674**

# FIG_1

# FIG_2

# FIG_3

1

0 016 674

# FIG. 4

# FIG. 5

2